# EUROPÄISCHE PATENTSCHRIFT

(11) **EP 2 522 040 B1**
(45) Veröffentlichungstag und Bekanntmachung des Hinweises auf die Patenterteilung: **13.11.2019**
(21) Anmeldenummer: 11700622.1
(22) Anmeldetag: 05.01.2011
(51) Int. Cl.: H01L 35/30

(54) **VORRICHTUNG ZUR ERZEUGUNG ELEKTRISCHER ENERGIE AUS EINEM WÄRMELEITENDEN MATERIAL**
DEVICE FOR GENERATING ELECTRIC ENERGY FROM A HEAT-CONDUCTING MATERIAL
DISPOSITIF POUR PRODUIRE DE L'ÉNERGIE ÉLECTRIQUE À PARTIR D'UN MATÉRIAU THERMOCONDUCTEUR

(30) Priorität: 08.01.2010 DE 102010004200
(43) Veröffentlichungstag der Anmeldung: 14.11.2012
(73) Patentinhaber: CPT Group GmbH, 30165 Hannover (DE)
(72) Erfinder: BRÜCK, Rolf, 51429 Bergisch Gladbach (DE); LIMBECK, Sigrid, 53804 Much (DE)
(86) Internationale Anmeldenummer: PCT/EP2011/050086
(87) Internationale Veröffentlichungsnummer: WO 2011/083116

(56) Entgegenhaltungen:
- WO-A2-2005/074463
- WO-A2-2008/013946
- JP-A- 2006 211 780

## Beschreibung

Die Erfindung betrifft eine Vorrichtung zur Erzeugung elektrischer Energie aus thermischer Energie, die mit einem wärmeleitenden Material zur Verfügung gestellt wird. Derartige Vorrichtungen werden z. B. thermoelektrische Generatoren genannt und können in Abgassystemen von Verbrennungskraftmaschinen von Kraftfahrzeugen eingesetzt werden.

Bei der Abgasbehandlung von mobilen Verbrennungskraftmaschinen, wie z. B. Otto- und Dieselmotoren, wird heute versucht, Abgase derart aufzubereiten, dass diese praktisch vollständig gereinigt an die Umwelt abgegeben werden. Zudem wird versucht, jegliche Form ungenutzt ausgestoßener Energie in eine nutzbare Energieform umzuwandeln.

Abgas aus einem Motor eines Kraftfahrzeugs besitzt thermische Energie, die durch einen Wärmekontakt auf ein wärmeleitendes Material übertragen und mittels eines thermoelektrischen Generators in elektrische Energie umgewandelt werden kann, um beispielsweise eine Batterie oder einen anderen Energiespeicher zu füllen und/oder elektrischen Verbrauchern die benötigte Energie direkt zuzuführen. Damit steht für den Betrieb des Kraftfahrzeugs Energie in größerem Umfang zur Verfügung.

Ein solcher thermoelektrischer Generator weist zumeist eine Mehrzahl thermoelektrischer Wandlerelemente auf. Thermoelektrische Materialien hierfür sind von einer Art, dass diese effektiv thermische Energie in elektrische Energie umwandeln können (Seebeck-Effekt) und umgekehrt (Peltier-Effekt). Der "Seebeck-Effekt" basiert auf dem Phänomen der Umwandlung von Wärmeenergie in elektrische Energie und wird zur Erzeugung thermoelektrischer Energie genutzt. Der "Peltier-Effekt" ist die Umkehrung des Seebeck-Effekts und ein Phänomen, welches mit Wärmeadsorbtion einhergeht und in Relation zu einem Stromfluss durch unterschiedliche Materialien verursacht wird. Der Peltier-Effekt ist beispielsweise zum thermoelektrischen Kühlen bereits vorgeschlagen worden.

Solche thermoelektrischen Wandlerelemente weisen bevorzugt eine Vielzahl von thermoelektrischen Elementen auf, die zwischen einer so genannten "Heißseite" und einer so genannten "Kaltseite" positioniert sind. Thermoelektrische Elemente umfassen z. B. wenigstens 2 Halbleiterquader (p- und n-dotiert), die auf ihrer Oberseite und Unterseite (hin zur "heißen Seite" bzw. "kalten Seite") wechselseitig mit elektrisch leitenden Brücken verbunden sind. Keramikplatten bzw. Keramikbeschichtungen und/oder ähnliche Materialien dienen zur Isolierung der Metallbrücken und sind somit bevorzugt zwischen den Metallbrücken angeordnet. Wird ein Temperaturgefälle beidseits der Halbleiterquader bereitgestellt, so bildet sich ein elektrisches Spannungspotential. An der einen Kontaktstelle wird dabei Wärme aufgenommen ("Warmseite"), wobei die Elektronen der einen Seite auf das energetisch höher liegende Leitungsband des folgenden Quaders gelangen. Auf der anderen Seite können die Elektronen nun Energie freisetzen, um wieder auf die andere Seite mit niedrigerem Energieniveau zu gelangen ("Kaltseite"). Somit kann sich bei einem entsprechenden Temperaturgefälle ein Stromfluss einstellen.

Der Einsatz entsprechender thermoelektrischer Generatoren für die Anwendung in Kraftfahrzeugen, insbesondere Personenkraftfahrzeugen, ist insoweit bereits vorbekannt, als dass die thermoelektrischen Generatoren im Abgasstrom eingesetzt werden, wobei die thermische Energie per Wärmestrahlung übertragen wird. Nachfolgend steht jedoch der Einsatz thermoelektrischer Generatoren an massiven wärmeleitenden Flächen im Vordergrund, sodass die thermische Energie per Wärmeleitung übertragen werden soll. Die Generierung von elektrischer Energie aus solchen Wärmequellen ist aber bislang nicht effizient genug.

Aus der WO 2008/013946 A2 ist bekannt, dass thermoelektrische Elemente an Vorsprüngen von beheizten Grundkörpern angeordnet sind. Ein möglicherweise inhomogenes Temperaturprofil an dem Vorsprung wurde dort jedoch bei der Anordnung der thermoelektrischen Elemente nicht berücksichtigt.

Aus der JP 2006 211780 A ist weiter eine thermische Isolation zwischen ein Grundkörper und das thermoelektrisches Element bekannt. Die thermische Isolation dient dabei zur thermischen Isolation des Kühlkörpers von dem Wärmeübertragungsbereich.

Aufgabe der vorliegenden Erfindung ist es demnach, die mit Bezug auf den Stand der Technik geschilderten Probleme zumindest teilweise zu lösen. Insbesondere soll ein thermoelektrischer Generator angegeben werden, der einen verbesserten Wirkungsgrad hinsichtlich der Umwandlung von bereitgestellter thermischer Energie in elektrische Energie ermöglicht und gerade auch für den (stationären) Dauerbetrieb und für die Extraktion der thermischen Energie aus einem wärmeleitenden Material geeignet ist.

Diese Aufgaben werden mit einer Vorrichtung gemäß den Merkmalen des Patentanspruchs 1 gelöst. Vorteilhafte Ausgestaltungen der erfindungsgemäßen Vorrichtung sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Die Vorrichtung zur Erzeugung elektrischer Energie umfasst mindestens einen beheizten wärmeleitenden Grundkörper mit mindestens einem Vorsprung und thermoelektrischen Elementen, die lateral an dem mindestens einen Vorsprung angebracht sind, wobei ein thermoelektrischer Wirkungsgrad eines jeden thermoelektrischen Elements und eine abgegebene Wärmeleistung des mindestens einen Vorsprungs aufeinander abgestimmt sind.

Bei dieser Vorrichtung handelt es sich insbesondere um einen so genannten thermoelektrischen Generator. Der beheizte Grundkörper kann beispielsweise durch eine Abgasleitung, einen Teil einer Verbrennungskraftmaschine oder durch einen sonstigen metallischen Körper gebildet sein. Auch andere wärmeleitende Materialien sind vorstellbar. Bevorzugt werden massive Körper mit einer hohen Wärmekapazität verwendet.

Die Beheizung des Grundkörpers kann durch eine Flamme, durch einen Abgasstrom, einen elektrischen Heizer, durch Wasser und/oder eine sonstige Wärmequelle realisiert sein. Der Grundkörper wird insbesondere intermittierend geheizt und gibt aufgrund seiner Wärmekapazität gleichmäßig Wärme über die gegenüberliegende Seite ab. Als Vorsprung ist beispielsweise ein Zapfen anzusehen, der aus dem beheizten Grundkörper gegenüberliegend der Heizung herausragt. Es sind vorzugsweise mehrere Vorsprünge ausgebildet, um die Oberfläche des Materials zu vergrößern und so eine größere Anzahl thermoelektrischer Elemente anzubringen. "Anbringen" bedeutet in diesem Zusammenhang unverlierbar befestigt, geklebt, verlötet, verschweißt, etc. oder gleichmäßig verteilt auf mindestens 50 % der Oberfläche des Vorsprungs, bevorzugt auf mindestens 80 % der Oberfläche des Vorsprungs, besonders bevorzugt auf mindestens 95 % der Oberfläche des Vorsprungs. Hierbei werden die thermoelektrischen Elemente so an den Vorsprüngen angebracht, dass sie im direkten thermischen Kontakt mit diesen stehen. Der beheizte Grundkörper bildet hierbei die Trennung zwischen der Heißseite und der Kaltseite des thermoelektrischen Elements, wobei sich die Vorsprünge in Richtung der Kaltseite erstrecken. Jeder Vorsprung hat regelmäßig einen Grund, eine Spitze bzw. eine Front sowie eine Umfangsfläche. Lateral meint in diesem Zusammenhang, dass die thermoelektrischen Elemente an der Umfangsfläche zwischen dem Grund und der Spitze bzw. der Front angebracht sind und entweder parallel zu dieser Fläche verlaufen und/oder in einem Winkel dazu stehen.

Insbesondere ist der Grundkörper ein Heizkörper einer Standheizung, so dass die auf dem Grundkörper angeordneten Vorsprünge in den Wasserkreislauf der Standheizung hineinragen. Eine Standheizung ist insbesondere für den Einsatz in Kraftfahrzeugen geeignet und bewirkt durch eine Vorerwärmung des Kühlwassers mittelbar eine Erwärmung der Brennkraftmaschine, so dass Kaltstartschädigungen vermieden werden. Zudem ermöglicht eine solche Standheizung auch eine Beheizung des Fahrzeuginnenraums. Mit dem Wasserkreislauf der Standheizung wird in diesem Fall die Kaltseite des thermoelektrischen Generators gebildet, so dass die auf dem Vorsprung angeordneten thermoelektrischen Elemente zwischen einer Heißseite (Grundkörper bzw. Heizkörper der Standheizung) und einer Kaltseite (Kühlwasser) positioniert sind.

Der Vorsprung erstreckt sich insbesondere über eine Länge zwischen Grund und Spitze von höchstens 40 mm [Millimeter], insbesondere höchstens 20 mm. Bei der Anordnung von mehreren Vorsprüngen auf dem Grundkörper weisen diese bevorzugt eine Dichte von höchstens einem Vorsprung pro Quadratzentimeter (1 Vorsprung/cm²) auf.

Aufgrund des Wärmeflusses im Vorsprung vom beheizten Grundkörper weg, weist z. B. ein zylindrischer Vorsprung ein inhomogenes Temperaturprofil und damit eine inhomogene Abgabe der Wärmeleistung entlang seiner Erstreckungsrichtung auf. Ein jedes thermoelektrisches Element hat einen thermoelektrischen Wirkungsgrad, der für eine gewisse Temperaturdifferenz ein Maximum (Wirkungsgradmaximum) erreicht. Der Begriff "thermoelektrischer Wirkungsgrad" meint hierbei den Quotienten aus abgegebener elektrischer Leistung und aufgenommener thermischer Leistung. Um für jedes thermoelektrische Element einen möglichst hohen Wirkungsgrad zu erreichen, wird die Art des thermoelektrischen Elements auf die jeweilige lokale Temperatur des Vorsprungs und damit an die Temperaturdifferenz zwischen Heißseite und Kaltseite abgestimmt.

Alternativ oder ergänzend kann der Wärmefluss vom Vorsprung zum thermoelektrischen Element hin gezielt (teilweise) behindert oder gefördert werden, z. B. um eine möglichst homogene Abgabe der Wärmeleistung zu erreichen und so eine Anpassung an den vorgegebenen thermoelektrischen Wirkungsgrad des thermoelektrischen Elements zu realisieren.

Eine weitere Möglichkeit der Anpassung des Temperaturprofils liegt in der Anpassung des Querschnitts des Vorsprungs. So kann dieser beispielsweise entlang seiner Erstreckungsrichtung verjüngend und/oder erweiternd gewählt werden, (teilweise) aus einem porösen Material bestehen und/oder eine (teilweise) rauhe Oberfläche aufweisen.

Auf diese Weise kann der Wirkungsgrad des thermoelektrischen Elements besonders einfach an die abgegebene Wärmeleistung des Vorsprungs angepasst werden.

Hierbei wird insbesondere auch vorgeschlagen, dass die thermoelektrischen Elemente lateral, also an einer Umfangsfläche, an dem mindestens einen Vorsprung angeordnet sind. Ebenso ist bevorzugt, dass alle thermoelektrischen Elemente den gleichen elektrischen Wirkungsgrad (bei der üblichen Einsatztemperatur) aufweisen. Zudem ist hierbei bevorzugt, dass die abgegebene Wärmeleistung des mindestens einen Vorsprungs an der gesamten Umfangsfläche (z. B. bezogen auf entsprechend kleine Referenzflächen) homogen bzw. im Wesentlichen gleich ist.

Gemäß einer bevorzugten Ausgestaltung der Vorrichtung weist der mindestens eine Vorsprung an einem beheizten wärmeleitenden Grundkörper an der Umfangsfläche die gleiche Temperatur auf. Der Begriff "gleich" bedeutet in diesem Zusammenhang, dass identische thermoelektrische Elemente an der gesamten Umfangsfläche des Vorsprungs einsetzbar sind. Dabei ist der Grundkörper bzw. der Vorsprung so gestaltet, dass bevorzugt Temperaturdifferenzen von weniger als 100 °C, insbesondere weniger 50 °C und ganz bevorzugt höchstens 20 °C auf der Umfangsfläche erreicht werden, insbesondere über alle (dynamischen und/oder statischen) Lastzustände bzw. Heizzustände. Insbesondere weicht die Temperatur maximal an der Umfangsfläche maximal 30 % vom Wirkungsgradmaximum der eingesetzten thermoelektrischen Elemente ab, bevorzugt sogar nur maximal 15 %. Erreicht man gleiche Temperaturen über die gesamte Umfangsfläche, entfällt das Erfordernis, verschiedene thermoelektrische Generatoren mit verschiedenen Wirkungsgradmaxima einzusetzen, um die jeweils abgegebene Wärmeleistung auf das Wirkungsgradmaximum des entsprechenden Generators abzustimmen.

Nachfolgend sind einige Materialien für thermoelektrische Elmente und deren maximale Einsatztemperatur beispielhaft aufgeführt:

| | |
|---|---|
| n-Typ: | Bi2Te3 [ca. 250 °C]; |
| | PbTe [ca. 500 °C]; |
| | Ba0,3Co3,95Ni0,05Sb12 [ca. 600 °C]; |
| | Bay(Co,Ni)4Sb12 [ca. 600 °C]; |
| | CoSb3 [ca. 700 °C]; |
| | Ba8Ga16Ge30 [ca. 850 °C]; |
| | La2Te3 [ca. 1100 °C]; |
| | SiGe [ca. 1000 °C]; |
| | Mg2(Si,Sn) [ca. 700 °C]; |

| | |
|---|---|
| p-Typ: | (Bi,Sb)2TE3 [ca. 200 °C]; |
| | Zn4Sb3 [ca. 380 °C]; |
| | TAGS [ca. 600 °C]; |
| | PbTe [ca. 500 °C]; |
| | SnTe [ca. 600 °C]; |
| | CeFe4Sb12 [ca. 700 °C]; |
| | Yb14MnSb11 [ca. 1000 °C]; |
| | SiGe [ca. 1000 °C]; |
| | Mg2(Si,Sb) [ca. 600 °C]. |

Bei der erfindungsgemäßen Vorrichtung ist mindestens ein thermoelektrisches Element durch mindestens einen ersten Wärmeisolator zumindest in einem Teilbereich von dem mindestens einen Vorsprung getrennt.

Um das Temperaturprofil des Vorsprungs anzupassen, wird ein erster Wärmeisolator vorgeschlagen, der an den Vorsprung (insbesondere an dessen Umfangsfläche) angebracht (z. B. als Beschichtung) ist und den Wärmefluss zum thermoelektrischen Element hin verringert. Dabei ist der Begriff "Wärmeisolator" so zu verstehen, dass der Wärmefluss durch diesen nicht vollständig verhindert sondern nur gehemmt wird. Der Wärmeisolator kann sich über einen oder mehrere Teilbereiche des Vorsprungs erstrecken oder diesen vollständig überdecken. Durch den zwischen Vorsprung und thermoelektrischem Element eingebrachten Wärmeisolator steht der Vorsprung mit dem thermoelektrischen Element zumindest in Teilbereichen nicht mehr in unmittelbarem Wärmekontakt, was durch den Begriff "getrennt" ausgedrückt wird.

Weiterhin wird vorgeschlagen, mehrere thermoelektrischer Elemente an einem Vorsprung einzusetzen, verschiedene thermoelektrische Elemente für verschiedene Vorsprünge zu verwenden sowie verschiedene thermoelektrische Materialien oder verschiedene Materialdicken für verschiedene Vorsprünge zu wählen.

Alternativ oder zusätzilich zum ersten Wärme isolator ist bei der erfindungsgemäßen Vorrichtung mindestens ein thermoelektrisches Element durch mindestens einen zweiten Wärmeisolator zumindest in einem Teilbereich von dem mindestens einen beheizten Grundkörper getrennt.

Hierbei wird der zweite Wärmeisolator bevorzugt zwischen einem dem Grundkörper am nächsten liegenden (benachbarten) thermoelektrischen Element und dem beheizten Grundkörper positioniert, um Spitzen im Temperaturprofil des Vorsprungs am grundkörperseitigen Ende (Grund) des Vorsprungs zu vermeiden und eine negative Beeinflussung (insbesondere durch Wärmestrahlung) der thermoelektrischen Elemente zu vermeiden. Bevorzugt wird der Wärmefluss durch den zweiten Wärmeisolator vollständig unterdrückt. Dieser kann aus dem gleichen Material wie der erste Wärmeleiter bestehen, jedoch auch ein anderes Material aufweisen. Der zweite Wärmeisolator kann sowohl auf Regionen nahe den Vorsprüngen beschränkt als auch als Beschichtung über den gesamten Grundkörper ausgeführt sein.

Gemäß einer weiteren bevorzugten Ausgestaltung der Vorrichtung hat der mindestens eine Vorsprung eine axiale Richtung und eine Querschnittsfläche, die in der axialen Richtung des Vorsprungs auf den thermoelektrischen Wirkungsgrad mindestens eines thermoelektrischen Elements abgestimmt ist.

Als axiale Richtung ist regelmäßig die Erstreckungsrichtung des Vorsprungs vom Grund zur Spitze bzw. Front hin zu verstehen. Die Querschnittsfläche des Vorsprungs wird in der Ebene senkrecht zur axialen Richtung betrachtet, so dass die Flächennormale parallel zur axialen Richtung verläuft. Hierbei ist der Vorsprung nun so ausgestaltet, dass er verschiedene Querschnittsflächen entlang der axialen Richtung aufweist. Dabei können sich die Querschnittsflächen beispielsweise in ihrer Form oder Kontur, ihrer Größe, in der Porösität und/oder den Wärmeleitungseigenschaften des Materials unterscheiden. Durch die Variation der Querschnittsfläche wird der Weg des Wärmeflusses verkürzt oder verlängert bzw. behindert oder begünstigt, so dass sich eine unterschiedliche Abstrahlung der Wärmeenergie über die Umfangsfläche und entlang der axialen Richtung ergibt. Auf diese Weise kann gezielt Einfluss auf das Temperaturprofil des Vorsprungs genommen werden, so dass dieses wiederum auf den thermoelektrischen Wirkungsgrad des thermoelektrischen Elements abgestimmt ist.

Gemäß einer weiteren bevorzugten Ausgestaltung der Vorrichtung weisen zumindest zwei thermoelektrische Elemente gleiche Wirkungsgradmaxima auf.

Werden mehrere thermoelektrische Elemente eingesetzt, so werden bevorzugt thermoelektrische Elemente mit gleichen Wirkungsgradmaxima verwendet, so dass eine Anpassung von Wirkungsgradmaximum und abgegebener Wärmeleistung aneinander nur durch die zuvor genannten Methoden erforderlich ist und eine Anpassung der Materialien entfallen kann. Somit weisen bevorzugt alle thermoelektrischen Elemente, die an der Umfangsfläche eines Vorsprungs angebracht sind, gleiche Wirkungsgradmaxima auf.

Die Erfindung findet besonders bevorzugt Anwendung in einem Kraftfahrzeug, insbesondere in einem Personenkraftfahrzeug mit einer Verbrennungskraftmaschine.

Die Erfindung sowie das technische Umfeld werden anhand der schematischen Figuren veranschaulicht. Es ist darauf hinzuweisen, dass die Figuren besonders bevorzugte Ausführungsvarianten zeigen, die Erfindung jedoch nicht darauf beschränkt ist. Es zeigen:
- Fig. 1:: eine erste Ausführungsvariante der Vorrichtung mit einem im Querschnitt angepassten Vorsprung,
- Fig. 2:: eine zweite Ausführungsvariante der Vorrichtung mit einem im Querschnitt angepassten Vorsprung sowie einem zusätzlichen ersten Wärmeisolator,
- Fig. 3:: eine dritte Ausführungsvariante der Vorrichtung mit mehreren thermoelektrischen Elementen,
- Fig. 4:: die Integration einer Vorrichtung zur Erzeugung elektrischer Energie aus heißem Abgas eines Kraftfahrzeugs, und
- Fig. 5:: ein Kraftfahrzeug mit einer entsprechenden Vorrichtung.

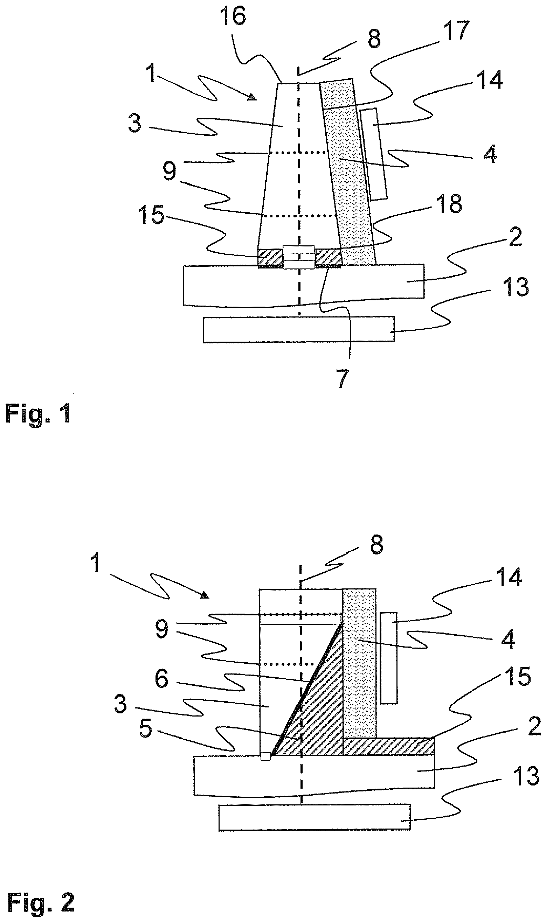

Fig. 1 veranschaulicht eine erste Ausführungsvariante der Vorrichtung 1 mit einem durch eine Heizung 13 (z. B. einen Brenner) beheizten Grundkörper 2 und mit einem Vorsprung 3, an dem lateral ein thermoelektrisches Element 4 angebracht ist, das von einer Kühlung 14 gekühlt wird. Der Vorsprung 3 ist in Teilabschnitten 7 durch zweite Wärmeisolatoren 15 von dem beheizten Grundkörper 2 getrennt, wodurch Temperaturspitzen am Grund 18 des Vorsprungs 3 vermieden werden. Weiterhin weist der Vorsprung 3 entlang seiner axialen Richtung 8 verschiedene Querschnittsflächen 9 auf, wodurch die vom Vorsprung 3 abgegebene Wärmeleistung an den Wirkungsgrad des thermoelektrischen Elements 4 angepasst ist. Bei der hier gezeigten Variante erstreckt sich ein thermoelektrisches Element 4 vom Grund 18 entlang der Umfangsfläche 17 bis hin zur Front 16 des Vorsprungs 3. Grundsätzlich kann aber die Anzahl und die Orientierung bzw. Positionierung der thermoelektrischen Elemente 4 zur Anpassung verschieden ausgeführt sein.

Die nachfolgenden Figuren führen teilweise gleiche Bauteile an, die dort auch mit denselben Bezugszeichen gekennzeichnet sind.

Fig. 2 zeigt eine zweite Ausführungsvariante der Vorrichtung 1. Der Vorsprung 3 ist in Teilbereichen 6 durch einen ersten Wärmeisolator 5 von den thermoelektrischen Elementen 4 getrennt und weist entlang der axialen Richtung 8 verschiedene Querschnittsflächen 9 auf. Auch der erste Wärmeisolator 5 weist verschiedene Querschnitte auf, die an die Querschnittsflächen 9 des Vorsprungs 3 angepasst sind. Die thermoelektrischen Elemente 4 sind lateral an dem Vorsprung 3 sowie dem ersten Wärmeisolator 5 angebracht und durch einen zweiten Wärmeisolator 15 von dem beheizten Grundkörper 2 getrennt. Die Anpassung der abgegebenen Wärmeleistung an den Wirkungsgrad des thermoelektrischen Elements 4 erfolgt in diesem Ausführungsbeispiel sowohl durch die Geometrie des ersten Wärmeisolators 5 sowie durch die verschiedenen Querschnittsflächen 9 des Vorsprungs 3.

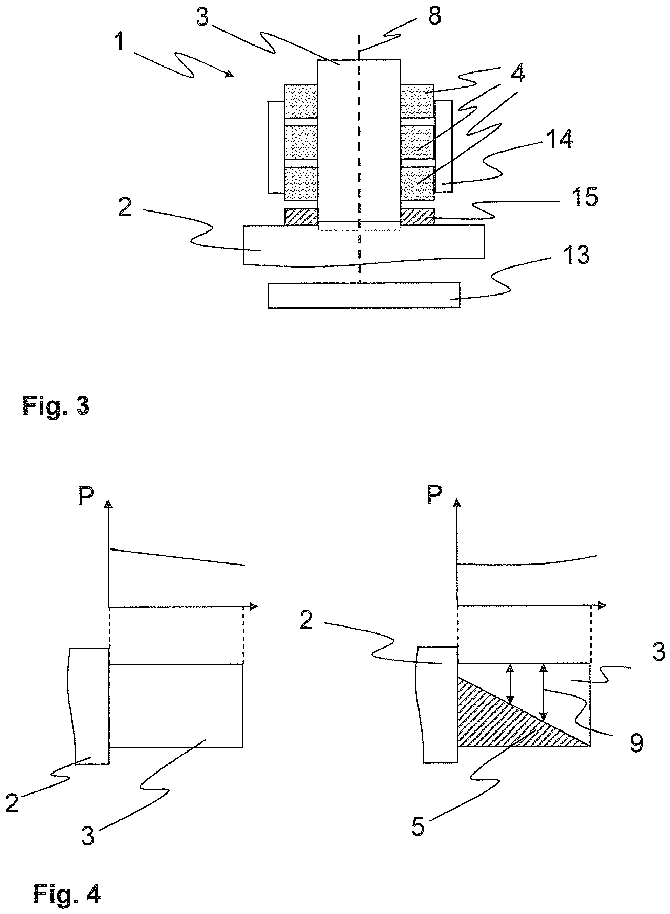

Fig. 3 zeigt eine dritte Ausführungsvariante der Vorrichtung 1. Die thermoelektrischen Elemente 4 sind durch einen zweiten Wärmeisolator 15 von dem beheizten Grundkörper 2 getrennt. Die Anpassung der abgegebenen Wärmeleistung des Vorsprungs an die Wirkungsgrade der thermoelektrischen Elemente 4 erfolgt dadurch, dass thermoelektrische Elemente 4 mit verschiedenen Wirkungsgradmaxima versehen sind.

Fig. 4 veranschaulicht die abgegebene Wärmeleistung des Vorsprungs 3. Die linke Grafik zeigt einen zylindrischen Vorsprung 3 ohne ersten Wärmeisolator 5. Dabei verringert sich die abgegebene Wärmeleistung P entlang der axialen Richtung 8 vom Grund hin zur Front. Die rechte Grafik zeigt einen Vorsprung 3 mit erstem Wärmeisolator 5 sowie verschiedenen Querschnittsflächen 9 des Vorsprungs 3 in axialer Richtung 8. Die abgegebene Wärmeleistung P steigt entlang der axialen Richtung 8 des Vorsprungs 3 an.

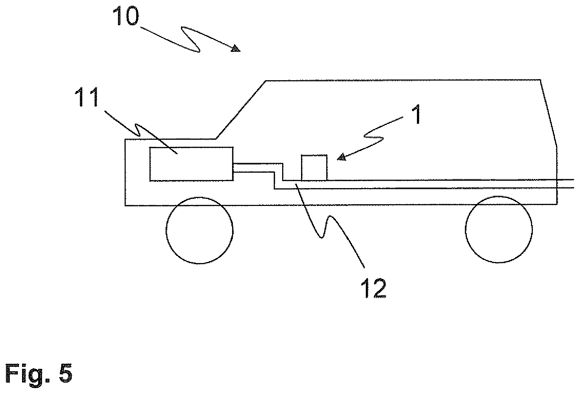

Fig. 5 zeigt ein Kraftfahrzeug 10 mit einer Verbrennungskraftmaschine 11, die ein Abgas 12 erzeugt, das über ein Abgassystem abgeleitet wird, welches in Wärmekontakt mit der Vorrichtung 1 steht. Somit kann aus der Wärmeenergie des Abgases 12 eines Kraftfahrzeugs 10 elektrische Energie gewonnen werden. Bevorzugt ist dabei, dass die Heizung des thermoelektrischen Generators nicht (allein) vom Abgas bereitgestellt wird, sondern vielmehr mindestens ein Brenner und/oder eine elektrische Heizung vorgesehen ist, die die massive Grundplatte mit einer gleichbleibenden Wärmezufuhr versorgt.

### Bezugszeichenliste

- 1: Vorrichtung
- 2: Grundkörper
- 3: Vorsprung
- 4: thermoelektrisches Element
- 5: erster Wärmeisolator
- 6: Teilbereich
- 7: Teilabschnitt
- 8: axiale Richtung
- 9: Querschnittsfläche
- 10: Kraftfahrzeug
- 11: Verbrennungskraftmaschine
- 12: Abgas
- 13: Heizung
- 14: Kühlung
- 15: zweiter Wärmeiso lator
- 16: Front
- 17: Umfangsfläche
- 18: Grund

## Patentansprüche

1. Vorrichtung (1) zur Erzeugung elektrischer Energie, umfassend mindestens einen beheizten wärmeleitenden Grundkörper (2) mit mindestens einem Vorsprung (3) und mehreren thermoelektrischen Elementen (4), die lateral an dem mindestens einen Vorsprung (3) angebracht sind, wobei ein thermoelektrischer Wirkungsgrad eines jeden thermoelektrischen Elements (4) und eine abgegebene Wärmeleistung des mindestens einen Vorsprungs (3) aufeinander abgestimmt sind, **dadurch gekennzeichnet, dass** mindestens ein thermoelektrisches Element (4) durch mindestens einen ersten zwischen Vorsprung und thermoelektrischem Element eingebrachten Wärmeisolator (5) zumindest in einem Teilbereich (6) von dem mindestens einen Vorsprung (3) getrennt ist.

2. Vorrichtung (1) nach Patentanspruch 1, wobei der mindestens eine Vorsprung an einem beheizten wärmeleitenden Grundkörper (2) an der Umfangsfläche (17) die gleiche Temperatur aufweist.

3. Vorrichtung (1) nach einem der vorhergehenden Patentansprüche, wobei mindestens ein thermoelektrisches Element (4) durch mindestens einen zweiten Wärmeisolator (15) zumindest in einem Teilabschnitt (7) von dem mindestens einen beheizten Grundkörper (2) getrennt ist.

4. Vorrichtung (1) nach einem der vorhergehenden Patentansprüche, wobei der mindestens eine Vorsprung (3) eine axiale Richtung (8) und eine Querschnittsfläche (9) hat, die in der axialen Richtung (8) des Vorsprungs (3) auf den thermoelektrischen Wirkungsgrad mindestens eines thermoelektrischen Elements (4) abgestimmt ist.

5. Vorrichtung (1) nach einem der vorhergehenden Patentansprüche, wobei mindestens zwei thermoelektrische Elemente (4) gleiche Wirkungsgradmaxima aufweisen.

## Claims

1. Apparatus (1) for generating electrical energy, comprising at least one heated thermally conductive main body (2) comprising at least one projection (3) and a plurality of thermoelectric elements (4) which are attached laterally to the at least one projection (3), wherein a thermoelectric efficiency of each thermoelectric element (4) and a heat output emitted by the at least one projection (3) are matched to one another, **characterized in that** at least one thermoelectric element (4) is separated from the at least one projection (3) by at least one first heat insulator (5), which is inserted between the projection and the thermoelectric element, at least in a subregion (6).

2. Apparatus (1) according to Patent Claim 1, wherein the at least one projection on a heated thermally conductive main body (2) has the same temperature on the circumferential face (17).

3. Apparatus (1) according to either of the preceding patent claims, wherein at least one thermoelectric element (4) is separated from the at least one heated main body (2) by at least one second heat insulator (15) at least in a subregion (7) .

4. Apparatus (1) according to one of the preceding patent claims, wherein the at least one projection (3) has an axial direction (8) and a cross-sectional area (9) which, in the axial direction (8) of the projection (3), is matched to the thermoelectric efficiency of at least one thermoelectric element (4).

5. Apparatus (1) according to one of the preceding patent claims, wherein at least two thermoelectric elements (4) have the same maximum efficiencies.

## Revendications

1. Dispositif (1) pour générer de l'énergie électrique, comprenant au moins un corps de base (2) conducteur de chaleur chauffé qui comprend au moins une partie saillante (3) et plusieurs éléments thermoélectriques (4) qui sont montés latéralement sur l'au moins une partie saillante (3), un rendement thermoélectrique de chacun des éléments thermoélectriques (4) et une puissance calorifique délivrée de l'au moins une partie saillante (3) étant accordés l'un sur l'autre, **caractérisé en ce qu'**au moins un élément thermoélectrique (4) est séparé de l'au moins une partie saillante (3) au moins dans une zone partielle (6) par au moins un premier isolateur thermique (5) incorporé entre la partie saillante et l'élément thermoélectrique.

2. Dispositif (1) selon la revendication 1, l'au moins une partie saillante sur un corps de base (2) conducteur de chaleur chauffé présentant la même température sur la surface périphérique (17).

3. Dispositif (1) selon l'une des revendications précédentes, au moins un élément thermoélectrique (4) étant séparé de l'au moins un corps de base (2) chauffé par au moins un deuxième isolateur thermique (15) au moins dans une portion partielle (7) .

4. Dispositif (1) selon l'une des revendications précédentes, l'au moins une partie saillante (3) possédant une direction axiale (8) et une surface de section transversale (9) qui, dans la direction axiale (8) de la partie saillante (3), est accordée sur le rendement thermoélectrique d'au moins un élément thermoélectrique (4).

5. Dispositif (1) selon l'une des revendications précédentes, au moins deux éléments thermoélectriques (4) possédant le même maximum de rendement.
